(19) **Europäisches Patentamt**
**European Patent Office**
**Office européen des brevets**

(11) **EP 1 535 375 B1**

(12) **EUROPEAN PATENT SPECIFICATION**

(45) Date of publication and mention
of the grant of the patent:
**11.04.2007 Bulletin 2007/15**

(51) Int Cl.:
**H01S 5/0625** (2006.01)

(21) Application number: **03791152.6**

(86) International application number:
**PCT/IE2003/000116**

(22) Date of filing: **29.08.2003**

(87) International publication number:
**WO 2004/021534 (11.03.2004 Gazette 2004/11)**

(54) **COMPENSATION OF MODE JUMPS IN TUNABLE MULTI SECTION LASERS**

KOMPENSATION VON MODENSPRÜNGEN IN DURCHSTIMMBAREN LASERN MIT MEHREREN SEKTIONEN

COMPENSATION DE SAUTS DE MODE DANS DES LASERS MULTISECTION REGLABLES

(84) Designated Contracting States:
**AT BE BG CH CY CZ DE DK EE ES FI FR GB GR HU IE IT LI LU MC NL PT RO SE SI SK TR**

(30) Priority: **02.09.2002 IE 20020709**

(43) Date of publication of application:
**01.06.2005 Bulletin 2005/22**

(73) Proprietor: **Intune Technologies Limited**
**Dublin 12 (IE)**

(72) Inventors:
- **FARRELL, Tom**
**Dublin 12 (IE)**
- **RYAN, Neil**
**Dublin 12 (IE)**
- **LEVINS, John**
**Dublin 12 (IE)**

(74) Representative: **Lane, Cathal Michael et al**
**Tomkins & Co.**
**5 Dartmouth Road**
**Dublin 6 (IE)**

(56) References cited:
**EP-A- 1 172 905**      **WO-A-99/40654**
**WO-A-03/038954**

- **SARLET G ET AL: "CONTROL OF WIDELY TUNABLE SSG-DBR LASERS FOR DENSE WAVELENGTH DIVISION MULTIPLEXING" JOURNAL OF LIGHTWAVE TECHNOLOGY, IEEE. NEW YORK, US, vol. 18, no. 8, August 2000 (2000-08), pages 1128-1138, XP000989390 ISSN: 0733-8724**
- **STARING A A M ET AL: "WAVELENGTH-INDEPENDENT OUTPUT POWER FROM AN INJECTION-TUNABLE DBR LASER" IEEE PHOTONICS TECHNOLOGY LETTERS, IEEE INC. NEW YORK, US, vol. 6, no. 2, 1 February 1994 (1994-02-01), pages 147-149, XP000439738 ISSN: 1041-1135**
- **DELORME F: "WIDELY TUNABLE 1.55-MUM LASERS FOR WAVELENGTH-DIVISION-MULTIPLEXED OPTICAL FIBER COMMUNICATIONS" IEEE JOURNAL OF QUANTUM ELECTRONICS, IEEE INC. NEW YORK, US, vol. 34, no. 9, 1 September 1998 (1998-09-01), pages 1706-1716, XP000781930 ISSN: 0018-9197**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

<u>Field of the Invention</u>

The invention relates to tunable lasers, particularly to a multi section laser diode that can be switched between different wavelengths or frequencies and more particularly to a method and system adapted to compensate for variations in tuning efficiency and power of a laser.

<u>Background to the Invention</u>

Multi section laser diodes are well known in the art and can be switched between different wavelengths. Typically the diode is calibrated at manufacture to determine the correct control currents that should be applied to the laser so as to affect the desired output frequencies from the laser.

One of the first known multi-section laser diodes is a three-section tunable distributed Bragg reflector (DBR) laser. Other types of multi-section diode lasers are the sampled grating DBR (SG-DBR), the superstructure sampled DBR (SSG-DBR) and the grating assisted coupler with rear sampled or superstructure grating reflector (GCSR). A review of such lasers is given in *Jens Buus, Markus Christian Amann, "Tunable Laser Diodes" Artect House, 1998 and "Widely Tunable Semiconductor Lasers" ECOC'00. Beck Mason.*

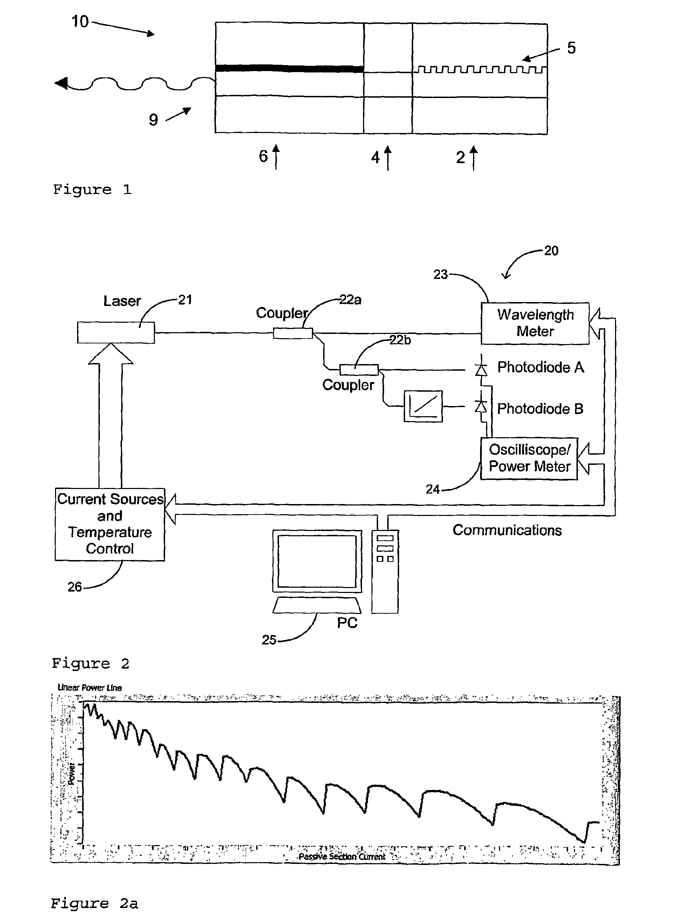

Figure 1 is a schematic drawing of a DBR 10. The laser comprises of a Bragg reflector sections 2 with a gain or active section 6 and phase section 4. An anti-reflection coating 9 is sometimes provided on the front and/or rear facets of the chip to avoid facet modes. The Bragg reflector take the form of Bragg gratings 5. The pitch of the gratings of the Bragg reflector vary slightly to provide a Bragg mode which moves in frequency through varying the current supplied to these sections. The optical path length of the cavity can also be tuned with the phase section, for example by refractive index changes induced by varying the carrier density in this section. A more detailed description of the DBR and other tunable multi-section diode lasers can be found elsewhere *Jens Buus, Markus Christian Amann, "Tunable Laser Diodes" Artect House, 1998.*

As detailed above such tunable semiconductor lasers contain sections where current is injected to control the output frequency, mode purity and power characteristics of the device. Various applications in telecommunications/sensor fields require that the laser can operate at points in a predetermined frequency/wavelength grid; moreover many applications require the power output of the device to be within a defined tolerance for each operating point, and in general, the operating points must be distanced from mode jumps and have high side-mode suppression. In order to provide lasers for such applications, each individual device must be characterised to the desired specification, so there is a corresponding need for a system or algorithm to map the output of the laser over a range of operating currents. For characterisation of lasers in production environments, such a system must also be fast, reliable and automated.

The rate of change of the output frequency of the tunable laser for a given change in current is called the tuning efficiency of the laser. This parameter has the characteristic that it is not constant and tends to saturate at higher input currents. This variation can be quite considerable (greater than an order of magnitude) across the tuning range of the device. A consequence of this variation in tuning efficiency is that mode jumps in the tuning space of the laser may not be distributed linearly with drive current, which can cause problems for a calibration algorithm that is attempting to find the operating points of the laser with high mode purity.

A direct and accurate approach to measuring the tuning efficiency of a device, or to map the frequency output of the device, is to increment the section current(s) with which frequency changes and to accurately measure the frequency at each point. A problem with this approach, as described in "Fast Accurate Characterisation of a GCSR laser over the complete EDFA Band" *Tom Farrell et al. LEOS'99 November, San Francisco,* is that for certain device types, the tuning efficiency at low coarse tuning section current is very high, forcing a particularly low step size for this section. For example in the DBR (Distributed Bragg Reflector) laser, the tuning efficiency will be very high at low DBR passive section current. To apply this low step size over the entire operational range of the DBR section is time consuming. In production environments this approach is generally too inefficient to be commercially viable. Another problem of using a single step size over the operational range of the section current is that, since the data measured is varying non-linearly, a characterisation algorithm searching for features in the data (such as the mode boundaries) must find a means of coping with this non-linear variation.

It is known that the output power of a device will fall off as the current in the passive sections is increased. Thus for measurements taken at fixed gain section current, the operating points may not fall within the required range of specified power outputs. Thus combining a series of measurements at different fixed gain currents, where the passive section currents are ramped as before, may be needed to produce the final set of operating points satisfying all the power, frequency and mode purity (SMSR) requirements. This of course adds extra time and analysis to the process, again an important issue in assessing the viability of a method for use in production environments.

There is therefore a need to provide a method and system that enables a compensation in the variation in tuning efficiency and power of the laser diode to be effected.

Mode width variations (modulation) has not been quantified by anyone heretofore which can provide a parameter to give a qualification of the laser performance. A method of measuring the mode modulation of a tunable laser is desirable. This measurement is based on the variations in mode width of a tunable laser for different output wavelengths of the laser. This measurement shows a clear performance characteristic of a tunable laser and the measurement for an ideal laser shows no mode width variation over the tuning range of the device. Mode width variations (modulation) is caused normally by internal reflections between sections of the laser and is an undesirable effect. A problem with these reflections is that they produce an undesirable effect. The larger the mode width the more tolerant the device is to ageing effect. As the laser ages the mode positions will move due to a breakdown in the material. If the mode width is small the laser can only tolerate small changes in the mode position hence the larger the mode width the longer the lifetime of the device. It has not been possible to date to effectively measure the mode width to enable a user to determine the performance of a tunable laser.

The Journal of Lightwave Technology, IEEE, New York Us (08-2000),18(8), 1128-1138 discloses a feedback control scheme that ensures frequency stability and accuracy. The active section voltage is monitored to maintain mode stability and a highly stable Fabry--Perot etalon is used as a reference to lock the laser frequency to a specific ITU channel. It also discloses a characterization scheme that uses the voltage monitoring to generate a look-up table of operation points.

Ieee Photonics Technology Letters, Ieee Inc, New York, Us (01-02-1994), 6(2), 147-149 discloses an injection-tunable three section Distributed Bragg Reflector laser emitting near 1.55um which has been fabricated employing bulk 1.48-um bandgap InGaAsP in the tuning layer of the phase and Bragg sections. The gain in this material has been adapted to compensate for the increased absorption loss during tuning, which results in a nearly wavelength-independent optical output power.

Neither of the above references compensate for non-linearity in tuning efficiency.

Object of the Invention

It is an object of the present invention to provide a method and system for efficiently compensating for variation in tuning efficiency and power of a laser diode. Another object of the present invention is to provide a method to effectively measure the mode width and modulation of a tunable laser further increasing the tuning efficiency and power of a laser diode.

Summary of the Invention

Accordingly the present invention provides a method of compensating for variation in tuning efficiency and power of a multi-section tunable laser diode. The methodology and system as set out in the appended claims is advantageous in that it is generic and can be applied to several types of tunable lasers such as DBR, SG-DBR, SSG-DBR, GCSR etc.

In a preferred embodiment the invention provides a method and system of normalising the output values of a laser diode, the method comprising the steps of varying the control currents for a specific section of a laser diode device over a range of values in a non-linear sample index so as to obtain a set of output values for that section of the laser diode, and normalising the set of output values to compensate for non-linearities in the output values by effecting a change in relationship between the control currents and the non-linear sample index, said non-linear sample index is effected by a non-linear transform applied to a linear current sample index, thereby changing the control currents and the output values such that application of the non-linear transform effects an equalisation of mode width to obtain a uniform mode width step size for subsequent calibration of the laser.

The advantage of the present invention is that the measurements are performed on a linear output wavelength axis rather than input current to the laser. This provides a better sampling resolution and any features in the data such as mode jumps occurring at a fixed wavelength tuning rate.

Another advantage is that the output power equalisation of the output light from a laser can be performed in a much easier fashion by adjusting the output power to compensate for losses in the laser due to increased current in the tuning sections of the laser.

The output values are desirably representative of power or frequency.

The method may be further used to obtain sets of normalised values for one or more further sections of the laser.

The generated transform may be subsequently used to effect the generation of a further set of output values for multiple combinations of control currents or sections for the laser device, the generated set having being normalised due to the utilisation of the transform.

In one embodiment, the normalisation of the output values is effected using the current of the mode jumps.

The mode jumps are typically detected by a power measurement, and are more typically detected by an observation of discontinuities in a power measurement.

In an alternative embodiment the mode jumps are detected by a frequency measurement, and in such an embodiment are typically represented by a step in a frequency measurement.

The method may be further used to determine deviations in mode width, thereby providing indications of the integrity of the laser device.

The normalisation may be effected using a relative loss of that section as a function of control current. The gain current of the laser device can be altered using said normalisation.

The normalisation of output values may be used to provide for a determination of location of modes.

The method may include the further step of determining suitable operating points, the operating points being selectable on the basis of a determination of a mid-point in frequency values for a specific mode. The operating point is typically at the mean frequency for that mode and benefits from maximum side mode suppression.

The modes are desirably locatable by effecting a differentiating of the normalised values.

There is also provided a computer program comprising program instructions for causing a computer program to carry out the above method, which may be embodied on a record medium, carrier signal or read-only memory.

These and other features of the present invention will be better understood with reference to the following drawings.

Brief Description of the Drawings

Figure 1 is a schematic drawing of a known laser diode,

Figure 2 is a schematic showing a conventional wavelength measuring apparatus and control system,

Figure 2a shows the output power of a device at uniform current intervals in the direction that the tuning efficient variations are to be suppressed,

Figure 2b shows the output power range of Figure 2a, but with the effects of the tuning efficiency variation suppressed,

Figure 3 shows a high-resolution power line as taken along a full range of DBR passive current sections and at a constant phase current and also indicates the position of mode jumps,

Figure 4 is a graphical representation of a polynomial correction tuning efficiency approximation, according to the present invention,

Figure 5 is a graphical representation of polynomial scaled to a desired sample and current range according to the present invention,

Figure 6 is an example of a linear power plane,

Figure 7 is an example of a non-linear power plane over the same range of values as Figure 6, as provided by the methodology of the present invention,

Figure 8 is a plot of mode width verses bragg current for a laser diode device with mode modulation,

Figure 9 is a plot of mode width variation verses frequency for a laser with mode modulation,

Figure 10 is a normalised version of the plot of Figure 9 with the % mode width variation converted to frequency modulation,

Figure 11 is an intensity map of power vs two control currents of a tunable laser mapped onto a Power vs. Total control current map,

Figure 12 shows a plurality of curves representing the loss of the front and back gain currents for a plurality of different gain currents, and

Figure 13 is a plot of gain current verses front and back current showing the required ratio between the parameters required to effect a desired power level for the device.

Figure 14 shows a series of operating points in the center of mode jump free regions denoted by the dots.

Figure 15 shows a plot of the operating points shown in figure 14 plotted as front current of mode center vs. mode index where mode index is the number representing each mode center starting from zero and incrementing by one.

Figure 16 shows a plot of the operating points shown in figure 14 plotted as back current of mode center vs. mode index where mode index is the number representing each mode center starting from zero and incrementing by one.

Detailed Description of the Drawings

The present invention provides a method of compensating for inefficiencies in tuning and power of a laser diode, specifically a multi-section tunable laser diode. The technique is generic and can be applied to several types of tuneable lasers such as DBR, SG-DBR, SSG-DBR, GCSR etc., although for ease of explanation it will now be described with reference to application to a DBR tuneable laser. It will be appreciated by those skilled in the art that this illustration is exemplary of the methodology of the present invention and it is not intended to limit the application to any one specific laser diode type.

The techniques used by the method of the present invention enable the formation of a set of output values, typically a power or frequency plane, which will be understood to be a series of power or frequency measurements at section current combinations within a specified range.

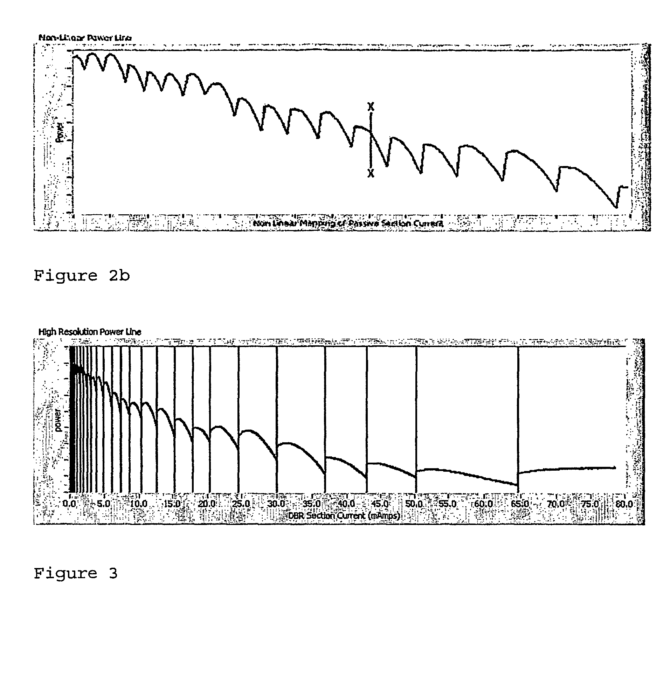

Referring now to Figure 2 there is illustrated a typical control system to implement the present invention generally indicated by the reference numeral 20. A laser 21 has an output connected to a coupler 22a, which in turn is connected to a another coupler 22b. The output of the coupler 22a, 22b are in communication with a wavelength meter 23, oscilloscope 24, a computer apparatus 25, for example a PC, and a current source temperature control device 26. This control system 20 provides a means to vary the control currents for a specific section of a laser diode device over a range of values in a first sample index so as to obtain a set of output values for that section of the laser diode and means to normalise the set of output values wherein the normalisation of the output values compensates for non-linearities in the output values by effecting a change in relationship between the control currents and the sample index. Typically the use of this type of control system can be used for the testing of laser devices prior to using such devices in any system for example telecommunications or instrumentation systems.

Using the technique of the present invention it is possible to provide for a more evenly spaced distribution of modes in the resultant data set which is advantageous in that it enables simpler and more effective analysis techniques. The method of the present invention also provides for a reduction in the size of the data set that requires analysis, thereby providing a more time and processing efficient system.

The methodology of the present invention will now be described with reference to a three section DBR type laser device. Firstly, a method to obtain the characteristics, preferably the tuning efficiency as provided by the frequency or power output, of the laser according to the present invention will be described. Using the resultant data set, the invention then provides for a technique to use this data and measure the characteristics of the laser while canceling out the tuning efficiency variation and the power loss due to increasing currents in the passive sections. An exemplary application of the technique will then be described with reference to a specific device

1. Automated Approximation of Laser Tuning Efficiency:

As detailed above, the present invention provides a methodology to determine a function to approximately map the tuning efficiency of the laser. It should be noted that according to the present invention, the tuning efficiency function is only required to determine a suitable set of sample to section current mappings; consequently the tuning efficiency itself is not required to any great accuracy, but it will be appreciated can be obtained accurately from measurements described in this patent application, and moreover measurements over a subset of the current space of the tunable laser are sufficient. This it will be appreciated provides for a time-efficient technique. For example, within a DBR laser, this subset would span the range of the DBR passive section current only, with the phase section current set at a constant value.

Although the present invention is not intended to be limited to any one specific theory or methodology it will for purpose of discussion be assumed that all that is needed to form a reasonably accurate approximation to the tuning efficiency of any device is the location of each mode jump of interest and the further assumption that frequency change across each jump is approximately uniform. To obtain each mode jump, a straight line is defined across passive section current space, which may be a function of one or more section currents. A series of power measurements is obtained along this function over small increments in current. The data is then discretely linearly filtered and thresholded to extract each mode jump.

This information, combined with the assumption that the frequency change across each mode jump is uniform, enables the mapping of approximately uniform steps in frequency to non-uniform steps in section current. If one has access to frequency data, however, or to a measure that varies in proportion with the frequency across the subset of section currents of interest, this may be utilised to form an equivalent mapping. As a result, it will be appreciated that the extraction of mode jump locations may not always be required.

Each set of discrete mappings or transforms is plotted for each contributing passive section. Since each plot consists of discrete value mappings, one may choose to either interpolate between defined mappings or to define a continuous function, which, in a least squares sense, fits the defined mappings optimally. The user may then specify the subsection of currents which are of interest and the amount of power plane samples which are desired within that region. Each passive section function can then be scaled accordingly, and the resulting mappings used to define locations in section current which correspond to each power plane sample. The resulting power plane is then predominantly free of the effects due to tuning efficiency variation.

## 2. Use of Non-Linear Power Planes:

This method has been developed as the first step in a tunable laser calibration system, and is specifically adapted to compensate for the variations on output power of the device due to increasing losses in the passive sections which is cause by increasing the control currents of the laser so as to provide for the modes jumps to be represented by similar jumps in output power of the device, and thus more easily determined. The control system, for example as illustrated in figure 2, calibrates each device based upon power/frequency measurements obtained at section current combinations within a pre-defined range of currents. It will be appreciated that the system and methodology is not device specific, although, as stated above, the straight line over which mode frequency changes occur will vary in terms of the section currents from device to device.

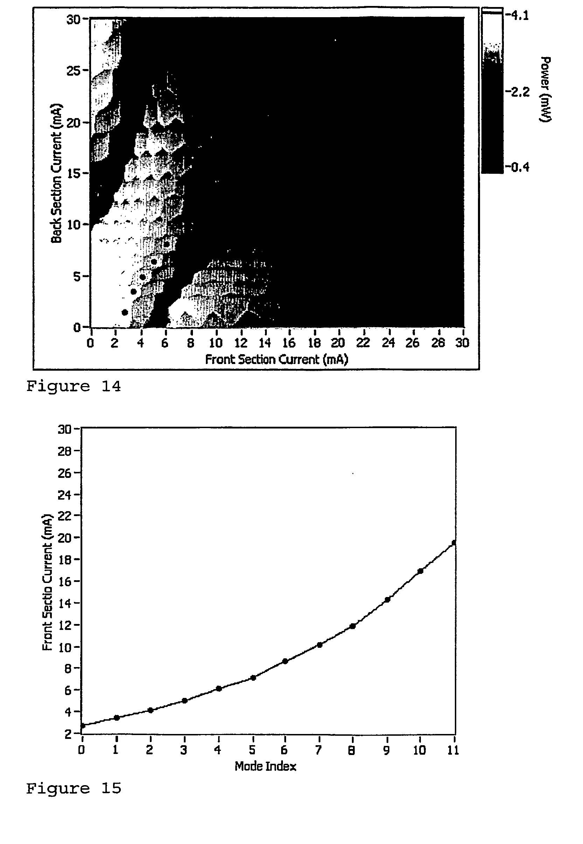

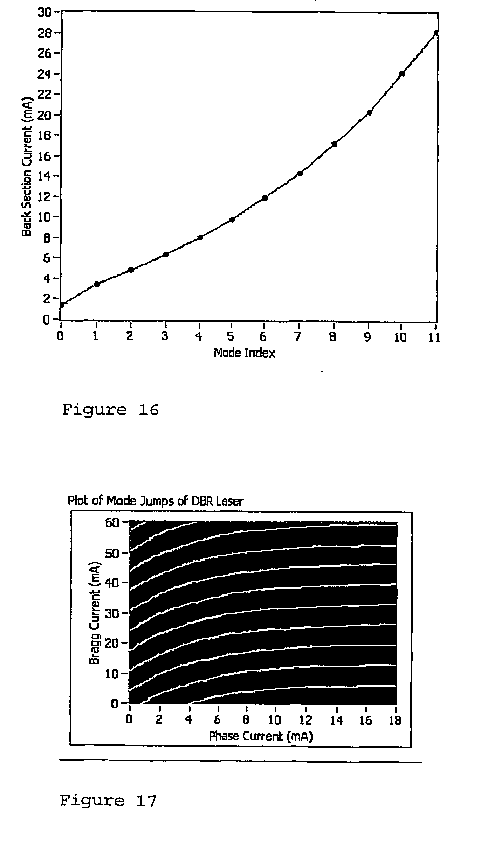

It will be understood therefore that for some devices, for example a SG-DBR type laser, non-linear power sampling may be required across more than one section current. In figure 14 a power plane for an SG-DBR laser is shown. A supermode is selected and the centre of regions where the output power has no mode jumps is selected and these points are denoted by dots. If as for a DBR laser the current at which these points occur is plotted against the mode index the graphs Figure 15 and Figure 16 are obtained for the Front and the Back sections of the laser. These represent the tuning rates of these sections and can be used in a similar way to that shown for the DBR laser.

It should be noted that a similar method can be used for a phase section of a laser also by plotting the position of a mode as a function of phase current and using a non-linear sampling rate to cancel any non-linear tuning of the phase section when measuring multiple planes.

## Benefits of Removing the Effects of Tuning Efficiency

Variations: The main benefit of removing the effects of tuning efficiency variations across the device, is to maximise the efficiency of a subsequent calibration algorithm with regard to the fact that each mode is represented by a uniform amount of points in the power plane, and that number is set as low as possible without compromising accuracy, i.e. that no mode is represented by too many or too few points. The advantage of the technique of the present invention is evident from a comparison of Figures 2a and 2b.

Fig. 2a displays the output power of a device at uniform current intervals in the direction that tuning efficiency variations are to be suppressed (linear power line). Fig. 2b displays the output power across the same range, but with the effects of tuning efficiency variation suppressed (i.e. a non-linear power line as provided by the technique of the present invention). It will be appreciated that a mode jump should be distinguishable by a discontinuity in power or frequency. It will be apparent from an inspection of the two Figures, that there is a large variation in the distance between mode jumps in the linear line relative to the non-linear line (Figure 2b). Although both lines contain the same amount of power samples, it is clear that there are not enough samples in the linear line to easily extract important signal characteristics at low currents. However, the equivalent data in the non-linear power line is easily extractable.

Another benefit of removing the effects of tuning efficiency variations across the device is that each point midway between two mode jumps (an instance of which is marked as the vertical line X-X in Fig. 2b) will also be the centre of its tuning range. This means that the point will be at the mean frequency for that mode, and will benefit from maximum side mode suppression. This makes it an ideal choice as the operating point for that mode.

## Measuring Frequency Modulation of a Laser using Mode Widths

As described previously the mode width (in current) at relative tuning currents in the laser describes the relationship between tuning rate and current(GHz/mA). It will be appreciated that the Mode Width is proportional to tuning rate vs. tuning current, which can be understood in terms of the Bragg current as meaning that the width of the mode in Bragg current is the relative size of the reflection peak that is causing the laser to operate at this frequency relative to the adjacent modes of lasing of the laser.

Using this relationship it is possible to obtain a plot of mode modulation of the laser. Mode modulation is caused by extra Fabry Perot cavities existing in the laser and is normally due to an undesirable reflection at the interface between the individual sections of the laser. These reflections when added to the desired reflections from the Bragg etc.. cause a modulation in the mode width of the laser.

The example below is shown for a DBR laser but the same method can be equally applied to any type of tunable laser.

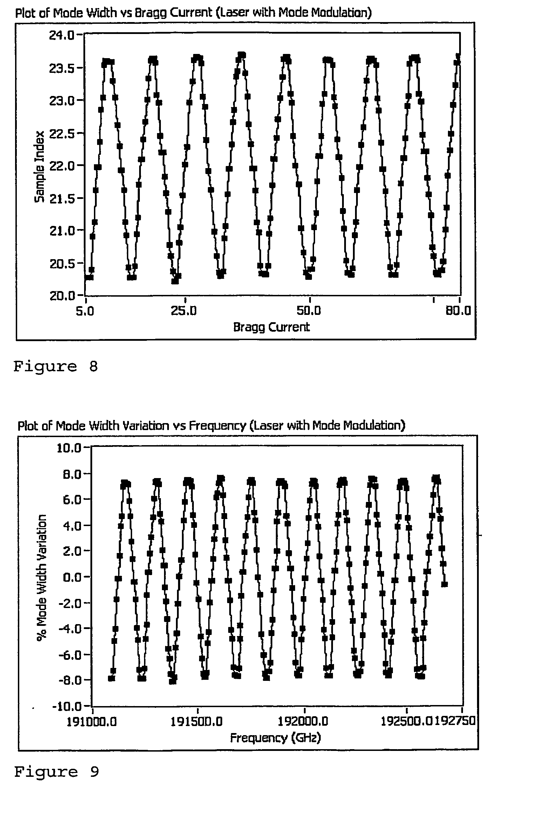

From a plot of DBR power (where the tuning currents have been normalised out, such as that shown in Figure 7) a plot of the mode jumps of the laser can be obtained by using differentiation and a threshold to obtain where steps in power occur. These steps in power represent the mode jumps of the laser and are shown in Figure 17

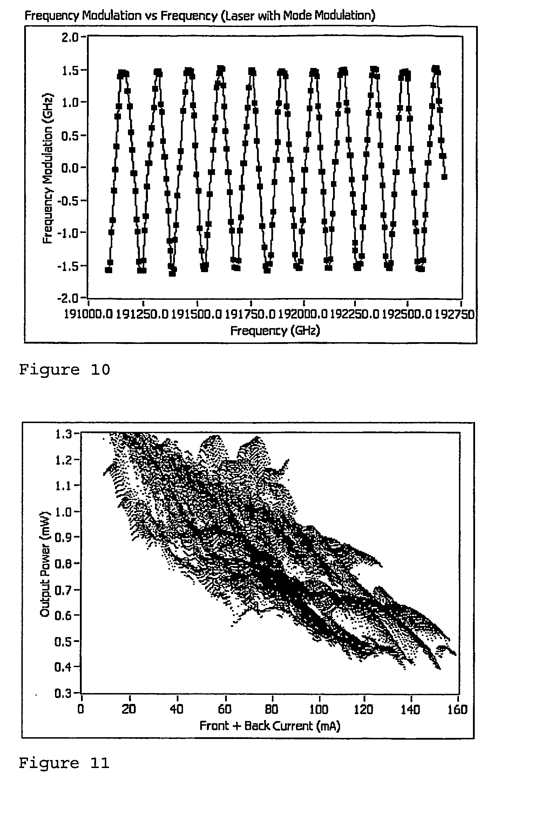

From this plot (Figure 17), if the mode jump width (in Bragg Current) is extracted as a function of Bragg current (where Bragg Current is the current in the middle of the mode where each mode width is measured) for all modes and all phase currents and a plot, such as that shown in Figure 8, is obtainable which provides for a graphical representation of the mode width of the laser vs. Bragg Current. As can be seen from the graph of Figure 8, this is a very uniform result and shows that the mode modulation is dependent directly on the Bragg current of the laser. This can be related directly to Frequency by converting Bragg current to Frequency with the aid of a plot of the tuning rate of the Bragg Section. Such a plot is shown in Figure 9 and can be obtained by some wavelength measurements such as a wavelength meter or equivalent or, as previously described by obtaining a plot of mode position vs Bragg current and sampling some frequencies either using a wavelength meter or using the setup as in Figure 2.

The plot of Frequency vs. Bragg is true for any points on all lines in-between each adjacent mode jump. As the laser has mode jumps the tuning away from each of these lines will be slightly different and a factor is required which is the relative frequency tuning range of a single mode of the laser for a fixed phase current. These values change from device to device but an exemplary DBR laser device may have values of the order of 12 GHz and the cavity mode jump is 70 GHz. Therefore, the factor we require is 12/70. If we multiply the frequency variation plot from above by this factor the frequency modulation of the device is obtained versus the absolute frequency of the laser. This is a relative value and shows deviations from the ideal uniform performance of the laser.

In Figure 10 the mode modulation is caused by a reflection between the gain section and the phase section of the laser and the period of modulation is approximately 125 GHz. This corresponds to a cavity length in the device of approx 340 $\mu$m which is as expected.

This measurement is a very good detector of internal reflection in the tuneable laser and can be obtained from a simple power plane of a tuneable laser. This measurement is fast and can be used in the characterisation of tuneable lasers in a production environment. As the result obtained can be easily thresholded to detect when the internal reflections are too large the device will not meet the required specification it is ideal for Pass/ Fail criterion required in an automated production system.

Measuring Power Loss Due to Increasing Currents in the Passive Sections:

All tuneable devices suffer power loss due to increasing currents in the passive sections. An objective of device calibration is to not only obtain operating points at pre-defined frequencies within the device band, but to ensure those points are of a certain output power level. Based upon an assumed relationship between power loss and passive section currents, the input gain current may be increased in such a way as to counter the loss.

The example below is for an SG-DBR laser but applies equally for a DBR laser, GCSR, SSG-DBR and other multi-section tuneable lasers.

If a coarse measurement of output power is measured on an SG-DBR laser and the output power is plotted against front current plus back current then a graph such as that in figure 11 is obtained.

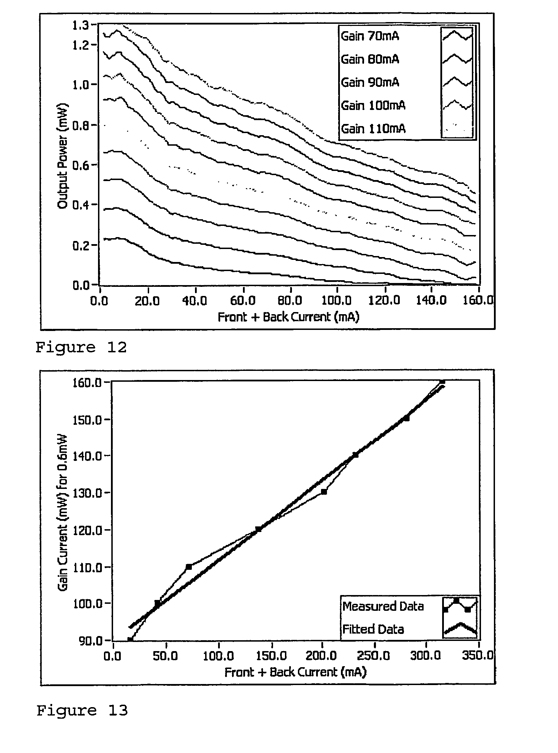

This shows how the output power of the device varies as a function of the passive current (excluding the phase current). If this plot is curve fitted to obtain the median output power (or some such other method is used such as averaging as shown in the figure 12) a curve which represents the loss of the front and back sections is obtained. If this is repeated for different gain currents a set of these curves can be obtained as in figure 12.

It is possible then, using this information, to select the output power required to operate the laser. This selected power will cut or bisect several of the curves obtained at each gain current in Figure 12. By plotting the gain current value from each curve against the front and back current value, a plot of gain current vs. Front and back current is obtained for the required output power value as shown in Figure 13. This plot enables determination of the ratio between front and back current verses the gain current required to obtain the required power level. This can be fitted with a linear or higher order polynomial or such method to get the relationship and a power plane can be re-measured where the gain current at each point on the plane is adjusted according to this relationship. This results in a power plane which will typically have 2dB of power variation as opposed to the 6dB for the case where the gain current is kept constant.

Using this technique to reduce the output power variation of a tuneable laser measurement plane enable power equalisation to be obtained in a much easier fashion as a large part of the power variation has already been compensated for. Also this allows easier detection of changes in the power level which denote mode jumps of the laser. As the power variation is reduced the variation in these jumps of power will be similar in size and allow easier detection.

3. Example:

The techniques of the present invention described above will now be described with reference to an example of tuning efficiency approximation for a DBR tuneable device. As was shown in Figure 1, this is a three section device, with two passive sections, phase 4 and DBR 2, and an active section, gain 6. In this particular type of device, mode jumps tend to occur with increasing DBR passive section current. Hence, a high-resolution power line was taken along the full range of DBR current and at a constant phase current (Fig. 3), and the location of mode jumps identified. The sample control system as illustrated in Figure 2 calibrates each device based upon power/frequency measurements.

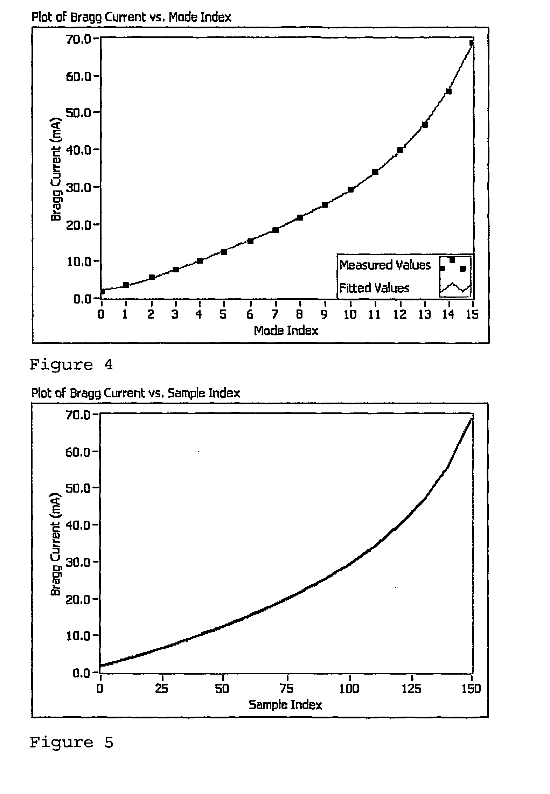

As shown in Figure 4, this data may be used to plot a DBR current versus frequency index relationship (each unit increase in value represents a uniform jump in frequency). A $2^{nd}$ order polynomial function was then fitted to this data, bound by its upper and lower limits. Both the original data and the fitted polynomial function are shown in Fig. 4. The fitted function for the specific data set illustrated is defined below:

$$f(x) = 0.1123x^2 + 0x + 0.0366 , \quad (1)$$

where x is the frequency index of the data. This it will be appreciated is a standard quadratic polynomial which maps uniform steps in frequency to non-uniform steps in section current across the full range of the device. In order to perform a full characterisation of the device, a subset of this entire range, i.e. a region of specific interest in both passive sections is then specified, along with a desired power plane size: i.e. how many data points are required for a specific range of currents. This range may be specified in terms of the maximum and minimum currents ($I_{high}$ and $I_{low}$). Using a specific example of utilising 300 power samples on the DBR passive section in the range between 0.99 and 45.09 mA inclusive, it is possible to transform the fitted function, defined by equation (1) into a sample index to section current value mapping, based upon this specified data. The function transformation is defined below (equation (2)), and it will be appreciated that the present invention is not intended to be limited to any specific values or polynomial function. It will be further noted that $f^1(I_{low})$ is $x$ at $f(x) = I_{low}$, and that the equivalent stands for $f^1(I_{high})$ (see Fig. 3 for the mapping between each x value and $I_{low}$ & $I_{high}$).

$$f(s) = \left( a \times \left( \frac{m}{k} \right)^2 \right) s^2 + \left( \left( (2 \times a \times f^{-1}(I_{low})) + b \right) \times \frac{m}{k} \right) s + \left( \left( a \times f^{-1}(I_{low})^2 \right) + \left( b \times f^{-1}(I_{low}) \right) + c \right)$$

$$(2)$$

where:

a = $x^2$ coefficient in $f(x)$.
b = $x$ coefficient in $f(x)$.
c = offset in $f(x)$.
$I_{low}$ = the lower threshold of the passive section current region of interest.
$I_{high}$ = the upper threshold of the passive section current region of interest.

$$m = f^{-1}(I_{high}) - f^{-1}(I_{low}) .$$

k = No. of sample periods across mapping range.
$s$ is the sample

Substituting the values specific to this example for the above, yields the polynomial defined in Equation (3) below, and plotted in Fig. 5:

$$f(s) = 0.00037s^2 + 0.03741s + 0.9872 \quad (3)$$

The solving of this polynomial maps each of 300 sample points to a section current within the specified range, based upon the original mapping function, $f(x)$ (equation 1). Since tuning efficiency does not vary significantly with phase section current, the mapping between sample index and section current remained linear, and hence a uniform step size was used between power samples. It is now possible to utilise the sample index to current mappings for each passive section in the measurement of a power plane.

It will be appreciated that there are other such methods to achieve the same result as the equations show above, for example using a conversion from current to wavelength ro frequency for each of the laser sections. This may be measured in the example provided as shown or other such methods to achieve the same result.

It will be appreciated that equations 1,2 and 3 can be implemented in a computer program or software for example C++ or visual basic in order to implement various aspects of the present invention, however it will be understood to the person skilled in the art that any computer program maybe used. It will be further appreciated that various aspects of the present invention could be implemented in a Field Programmable Gate Array (FPGA) or other logic hardware implementation.

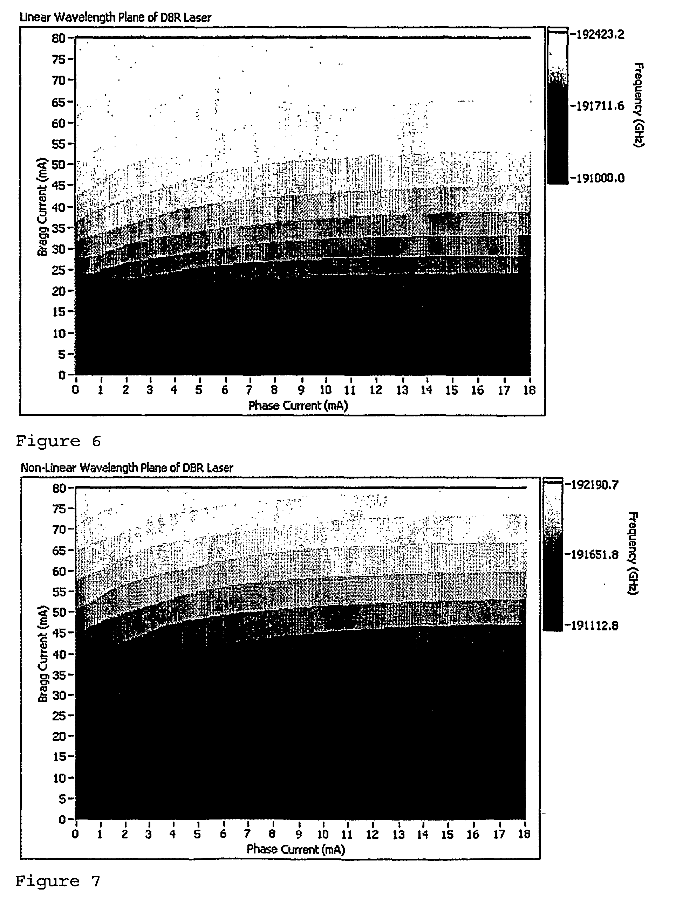

Shown in Figs. 6 and 7 is a comparison between a 300 x 300 linear power plane over the range of DBR currents described by the function of equation (3) and shown in Fig 5, and a non-linear plane over the same range of currents. The plane of Figure 6 is formed using conventional techniques such as those described in *"Fast Accurate Characterisation of a GCSR laser over the complete EDFA Band" Tom Farrell et al. LEOS' 99 November, San Francisco,* whereas that of Figure 7 is formed using the technique of the present invention. The relative uniformity of the width of each mode in the non-linear plane (Figure 7) is apparent especially when compared to the linear plane (Figure 6).

It will be appreciated that the specific example utilising a DBR type laser device enables the power plane characterising the device to be effected on a single measurement set. In application of the technique to other laser types it will be appreciated that several measurements may be required to fully characterise the device. For example using a SG-DBR device it is necessary to measure the output power vs. all of the coarse tuning currents, and for a 4-section SG-DBR laser this results in a plane. These measurements are repeated as a function of any other tuning sections that the device may have. For example with an SG-DBR laser several planes are measured of Front grating vs. Back grating against phase current.

It will be appreciated by those skilled in the art that although the example of the present invention has been described with reference to specific mathematical equations and techniques that many alternative techniques may be utilised to obtain the same effect or implementation as that provided by the specific example herein illustrated.

For a person skilled in the art hysteresis can be represented in a similar method to that of mode modulation. This means that the hysteresis of the mode jumps as a percentage of the mode width can be plotted as a function of the wavelength of the laser, where the wavelength of the laser is the output wavelength exactly in between the mode jumps. This allows an improved quantitative method of representing this effect similar to that of mode modulation.

It will be understood that the present invention provides for a method that compensates for tuning efficiency in a laser diode device, by providing a technique that enables a different sampling rate to be applied in different regions of interest in the power plane of the device.

It will be appreciated that the present invention provides for the provision of a graph of the relative tuning rates of a section of a multi-section tunable laser by finding the relative positions of modes in the laser. According to the present invention the mode widths can be used to get mode modulation of a tunable laser.

Also it will be appreciated that by effecting a change in the gain current while measuring a power plane for a laser, it is possible to compensate for power variation due to absorption in the passive sections of the laser.

The present invention additionally provides for the measurement of a plane which takes all of the above into account and compensates for the resulting in a measurement plane where either the relative size of modes is constant or the power jumps due to mode jumps are equalised.

The embodiments in the invention described with reference to the drawings comprise a computer apparatus and/or processes performed in a computer apparatus. However, the invention also extends to computer programs, particularly computer programs stored on or in a carrier adapted to bring the invention into practice. The program may be in the form of source code, object code, or a code intermediate source and object code, such as in partially compiled form or in any other form suitable for use in the implementation of the method according to the invention. The carrier may comprise a storage medium such as ROM, e.g. CD ROM, or magnetic recording medium, e.g. a floppy disk or hard disk. The carrier may be an electrical or optical signal which may be transmitted via an electrical or an optical cable or by radio or other means.

The invention is not limited to the embodiments hereinbefore described but may be varied in both construction and detail.

The words "comprises/comprising" and the words "having/including" when used herein with reference to the present invention are used to specify the presence of stated features, integers, steps or components but does not preclude the presence or addition of one or more other features, integers, steps, components or groups thereof.

**Claims**

1.    A method of normalising the output values of a laser diode, the method comprising the step of:

a) varying the control currents for a specific section of a laser diode device over a range of values in a non-linear sample index so as to obtain a set of output values for that section of the laser diode, **characterised in that** the method comprises the step of:

b) normalising the set of output values to compensate for non-linearities in the output values by effecting a change in relationship between the control currents and the non-linear sample index, said non-linear sample index is effected by a non-linear transform applied to a linear current sample index, thereby changing the control currents and the output values such that application of the non-linear transform effects an equalisation of mode width to obtain a uniform mode width step size for subsequent calibration of the laser.

2.    The method as claimed in claim 1 wherein the output values are representative of power or frequency.

3.    The method as claimed in claim 1 or 2 further comprising the step of obtaining a set of normalised values for one or more further sections of the laser.

4.    The method as claimed in claim 1 wherein the generated transform is subsequently used to effect the further generation of a set of output values for multiple combinations of control currents or sections for the laser device, the generated set having being normalised due to the utilisation of the transform.

5.    The method as claimed in claim 1 wherein the normalisation of the output values is effected using the current of the mode jumps.

6.    The method as claimed in claim 5 wherein mode jumps are detected by a power measurement.

7.    The method as claimed in claim 6 wherein the mode jumps are represented by discontinuities in a power measurement.

8.    The method as claimed in claim 5 wherein mode jumps are detected by a frequency measurement.

9.    The method as claimed in claim 6 wherein the mode jumps are represented by a step in a frequency measurement.

10.    The method as claimed in claim 1 further comprising the step of determining deviations in mode width, thereby providing indications of the integrity of the laser device.

11.    The method as claimed in claim 1 wherein the normalisation is effected using a relative loss of that section as a function of control current.

12.    The method as claimed in claim 11 wherein the gain current of the laser device can be altered using said normalisation.

13.    The method as claimed in claim 1 wherein the normalisation output values provides for a determination of location of modes.

14.    The method as claimed in claim 13 further comprising the step of determining suitable operating points, the operating points being selectable on the basis of a determination of a mid-point in frequency values for a specific mode.

15.    The method as claimed in claim 14 wherein the operating point is at the mean frequency for that mode and benefits from maximum side mode suppression.

16. The method as claimed in claim 13 wherein the mode are locatable by effecting a differentiating of the normalised values.

17. A computer program comprising program instructions for causing a computer to perform the method of any one of claims 1 to 16.

18. A computer program as claimed in claim 17 embodied on a record medium.

19. A computer program as claimed in claim 17 embodied on a carrier signal.

20. A computer program as claimed in claim 17 embodied on a read-only memory.

21. A control system for normalising the output values of a laser diode, the system comprising :

   means to vary the control currents for a specific section of a laser diode device over a range of values in a non-linear sample index so as to obtain a set of output values for that section of the laser diode; **characterised in that** the system comprises means to normalise the set of output values to compensate for non-linearities in the output values by effecting a change in relationship between the control currents and the non-linear sample index, said non-linear sample index is effected by a non-linear transform applied to a linear current sample index, thereby managing the control currents and the output values such that application of the non-linear transform effects an equalisation of mode width to obtain a uniform mode width step size for subsequent calibration of the laser.

22. The system as claimed in claim 21 wherein the output values are representative of power or frequency.

23. The system as claimed in claim 21 or 22 further comprising means for obtaining a set of normalised values for one or more further sections of the laser.

24. The system as claimed in claim 21 wherein the generated transform is subsequently used to effect the further generation of a set of output values for multiple combinations of control currents or sections for the laser device, the generated set having being normalised due to the utilisation of the transform.

25. The system as claimed in claim 21 wherein the normalisation of the output values is effected using the current of the mode jumps.

26. The system as claimed in claim 25 wherein mode jumps are detected by a power measurement.

27. The system as claimed in claim 26 wherein the mode jumps are represented by discontinuities in a power measurement.

28. The system as claimed in claim 25 wherein mode jumps are detected by a frequency measurement.

29. The system as claimed in claim 26 wherein the mode jumps are represented by a step in a frequency measurement.

30. The system as claimed in claim 21 further comprising means for determining deviations in mode width, thereby providing indications of the integrity of the laser device.

31. The system as claimed in claim 21 wherein the normalisation is effected using a relative loss of that section as a function of control current.

32. The system as claimed in claim 31 wherein the gain current of the laser device can be altered using said normalisation.

33. The system as claimed in claim 21 wherein the normalisation output values provides for a determination of location of modes.

34. The system as claimed in claim 33 further comprising means for determining suitable operating points, the operating points being selectable on the basis of a determination of a mid-point in frequency values for a specific mode.

35. The system as claimed in claim 34 wherein the operating point is at the mean frequency for that mode and benefits from maximum side mode suppression.

36. The system as claimed in claim 33 wherein the mode are locatable by effecting a differentiating of the normalised values.

**Patentansprüche**

1. Verfahren zum Normalisieren von Ausgangswerten einer Laserdiode mit folgenden Schritten:

   a) Verändern der Steuerströme an einer spezifischen Sektion eines Laserdioden-Bauelements über einen Wertebereich eines nicht-linearen Probenindex, um einen Satz von Ausgangswerten für die Sektion der Laserdiode zu erhalten, **gekennzeichnet durch** folgende Schritte:
   b) Normalisieren des Satzes von Ausgangswerten, um Nicht-Linearitäten in den Ausgangswerten **dadurch** zu kompensieren, dass eine Änderung in dem Verhältnis zwischen den Steuerströmen und dem nicht-linearen Probenindex erfolgt, wobei der nicht-lineare Probenindex **durch** eine nicht-lineare Transformation bewirkt wird, die auf einen linearen Strom-Probenindex angewendet wird, wodurch die Steuerströme und die Ausgangswerte verändert werden, so dass die Anwendung der nicht-linearen Transformation zu einer Entzerrung der Modenbreite führt, um so eine einheitliche Modenbreiten-Schrittgröße für die nachfolgende Kalibrierung des Lasers zu erhalten.

2. Verfahren nach Anspruch 1, wobei die Ausgangswerte die Leistung oder Frequenz darstellen.

3. Verfahren nach Anspruch 1 oder 2, **gekennzeichnet durch** den zusätzlichen Schritt eines Einholens eines Satzes von normalisierten Werten für eine oder mehrere weitere Sektionen des Lasers umfasst.

4. Verfahren nach Anspruch 1, wobei die erzeugte Transformation im folgenden dazu verwendet wird, eine weitere Erzeugung eines Satzes von Ausgangswerten für mehrere Kombinationen von Steuerströmen oder Sektionen für das Laser-Bauelement zu bewirken, wobei der erzeugte Satz durch Anwendung der Transformation normalisiert wurde.

5. Verfahren nach Anspruch 1, wobei die Normalisierung der Ausgangswerte unter Benutzung des Stromes der Modensprünge hervorgerufen wird.

6. Verfahren nach Anspruch 5, wobei Modensprünge durch eine Leistungsmessung ermittelt werden.

7. Verfahren nach Anspruch 6, wobei die Modensprünge durch Unstetigkeiten in einer Leistungsmessung dargestellt werden.

8. Verfahren nach Anspruch 5, wobei Modensprünge durch eine Frequenzmessung ermittelt werden.

9. Verfahren nach Anspruch 6, wobei die Modensprünge durch einen Schritt in einer Frequenzmessung dargestellt werden.

10. Verfahren nach Anspruch 1, wobei das Verfahren zusätzlich den Schritt eines Bestimmens von Abweichungen in der Modenbreite umfasst, wodurch Hinweise auf die Intaktheit des Laser-Bauelements zur Verfügung gestellt werden.

11. Verfahren nach Anspruch 1, wobei die Normalisierung unter Benutzung eines relativen Verlusts der Sektion als Funktion des Steuerstroms durchgeführt wird.

12. Verfahren nach Anspruch 11, wobei der Verstärkungsstrom des Laser-Bauelements unter Benutzung der Normalisierung verändert werden kann.

13. Verfahren nach Anspruch 1, wobei die Normalisierungs-Ausgangswerte eine Bestimmung der Modenlokalisierung ermöglichen.

14. Verfahren nach Anspruch 13, wobei das Verfahren zusätzlich den Schritt eines Bestimmens geeigneter Arbeitspunkte umfasst, wobei die Arbeitspunkte auf der Basis einer Bestimmung eines Mittel-Punkts von Frequenzwerten für eine spezifische Mode wählbar sind.

15. Verfahren nach Anspruch 14, wobei sich der Arbeitspunkt bei der mittleren Frequenz dieser Mode befindet und von einer maximalen Nebenmoden-Unterdrückung begünstigt wird.

16. Verfahren nach Anspruch 13, wobei die Moden durch Ausführen eines Differenzierens der normalisierten Werte lokalisierbar sind.

17. Ein Computerprogramm mit Programmanweisungen, die einen Computer dazu veranlassen, das Verfahren nach einem der Ansprüche 1 bis 16 auszuführen.

18. Computerprogramm nach Anspruch 17 auf einem Aufzeichnungsmedium ausgeführt.

19. Computerprogramm nach Anspruch 17 auf einem Trägersignal ausgeführt.

20. Computerprogramm nach Anspruch 17 in einem Nur-LeseSpeicher (read only memory) ausgeführt.

21. Steuersystem zum Normalisieren der Ausgangswerte einer Laserdiode, wobei das System folgendes aufweist:

Mittel zum Verändern der Steuerströme einer spezifischen Sektion eines Laserdioden-Bauelements über einen Wertebereich eines nicht-linearen Probenindex, um einen Satz von Ausgangswerten für die Sektion der Laserdiode zu erhalten, **dadurch gekennzeichnet, dass** das System Mittel zum Normalisieren des Satzes von Ausgangswerten aufweist, um Nicht-Linearitäten in den Ausgangswerten **dadurch** zu kompensieren, dass eine Änderung in in dem Verhältnis zwischen den Steuerströmen und dem nicht-linearen Probenindex herbeigeführt wird, wobei der nicht-lineare Probenindex durch eine nicht-lineare Transformation bewirkt wird, die auf einen linearen Strom-Probenindex angewendet wird, wobei die Steuerströme und die Ausgangswerte derart geregelt werden, dass die Anwendung der nicht-linearen Transformation eine Entzerrung der Modenbreite hervorruft, um so eine einheitliche Modenbreiten-Schrittgröße für die nachfolgende Kalibrierung des Lasers zu erhalten.

22. System nach Anspruch 21, wobei die Ausgangswerte die Leistung oder Frequenz darstellen.

23. System nach Anspruch 21 oder 22, wobei das System zusätzlich Mittel zum Erhalten eines Satzes von normalisierten Werten für eine oder mehrere weitere Sektionen des Lasers umfasst.

24. System nach Anspruch 21, wobei die erzeugte Transformation im folgenden zum Ausführen einer weiteren Erzeugung eines Satzes von Ausgangswerten für mehrere Kombinationen von Steuerströmen oder Sektionen für das Laser-Bauelement verwendet wird, wobei der erzeugte Satz durch Anwendung der Transformation normalisiert worden ist.

25. System nach Anspruch 21, wobei die Normalisierung der Ausgangswerte unter Benutzung des Stromes der Modensprünge durchgeführt wird.

26. System nach Anspruch 25, wobei Modensprünge durch eine Leistungsmessung ermittelt werden.

27. System nach Anspruch 26, wobei Modensprünge als Unstetigkeiten durch eine Leistungsmessung dargestellt sind.

28. System nach Anspruch 25, wobei Modensprünge durch eine Frequenzmessung ermittelt werden.

29. System nach Anspruch 26, wobei Modensprünge als Schritt in einer Frequenzmessung dargestellt sind.

30. System nach Anspruch 21, wobei das System zusätzlich Mittel zum Bestimmen von Abweichungen in der Modenbreite aufweist, wodurch Hinweise auf die Intaktheit des Laser-Bauelements zur Verfügung gestellt werden.

31. System nach Anspruch 21, wobei die Normalisierung unter Benutzung eines relativen Verlusts der Sektion in Funktion des Steuerstroms durchgeführt wird.

**EP 1 535 375 B1**

**32.** System nach Anspruch 31, wobei der Verstärkungsstrom des Laser-Bauelements unter Benutzung der Normalisierung veränderbar ist.

**33.** System nach Anspruch 21, wobei die Normalisierungs-Ausgangswerte eine Bestimmung der Modenlokalisierung ermöglichen.

**34.** System nach Anspruch 33, wobei das System zusätzlich Mittel zum Bestimmen geeigneter Arbeitspunkte umfasst, wobei die Arbeitspunkte auf der Basis einer Bestimmung eines Mittel-Punkts von Frequenzwerten für eine spezifische Mode wählbar sind.

**35.** System nach Anspruch 34, wobei sich der Arbeitspunkt bei der mittleren Frequenz für diese Mode befindet und von einer maximalen Nebenmoden-Unterdrückung begünstigt wird.

**36.** System nach Anspruch 33, wobei die Moden durch Ausführen eines Differenzierens der normalisierten Werte lokalisierbar sind.

**Revendications**

**1.** Procédé de normalisation des valeurs de sortie d'une diode laser, le procédé comprenant l'étape suivante :

a) varier les courants de commande pour une section spécifique d'un dispositif à diode laser sur une plage de valeurs dans un indice d'échantillon non linéaire afin d'obtenir une série de valeurs de sortie pour cette section de la diode laser, **caractérisé en ce que** le procédé comprend l'étape suivante :
b) normaliser la série de valeurs de sortie pour compenser les non-linéarités dans les valeurs de sortie en effectuant une modification dans la relation entre les courants de commande et l'indice d'échantillon non linéaire, ledit indice d'échantillon non linéaire est effectué par une transformée non linéaire appliquée à un indice d'échantillon de courant linéaire, changeant ainsi les courants de commande et les valeurs de sortie de sorte que l'application de la transformée non linéaire effectue une égalisation de la largeur de mode pour obtenir une taille d'étape de largeur de mode uniforme pour un étalonnage ultérieur du laser.

**2.** Procédé selon la revendication 1, dans lequel les valeurs de sortie sont représentatives de la puissance ou de la fréquence.

**3.** Procédé selon la revendication 1 ou 2, comprenant en outre l'étape consistant à obtenir une série de valeurs normalisées pour une ou plusieurs sections supplémentaires du laser.

**4.** Procédé selon la revendication 1, dans lequel la transformée générée est par la suite utilisée pour effectuer la génération supplémentaire d'une série de valeurs de sortie pour de multiples combinaisons de courants de commande ou sections pour le dispositif laser, la série générée ayant été normalisée en raison de l'utilisation de la transformée.

**5.** Procédé selon la revendication 1, dans lequel la normalisation des valeurs de sortie est effectuée en utilisant le courant des sauts de mode.

**6.** Procédé selon la revendication 5, dans lequel les sauts de mode sont détectés par une mesure de la puissance.

**7.** Procédé selon la revendication 6, dans lequel les sauts de mode sont représentés par des discontinuités dans une mesure de la puissance.

**8.** Procédé selon la revendication 5, dans lequel les sauts de mode sont détectés par une mesure de la fréquence.

**9.** Procédé selon la revendication 6, dans lequel les sauts de mode sont représentés par une étape dans la mesure de la fréquence.

**10.** Procédé selon la revendication 1, comprenant en outre l'étape consistant à déterminer les déviations de largeur de mode, fournissant ainsi des indications de l'intégrité du dispositif laser.

14

**11.** Procédé selon la revendication 1, dans lequel la normalisation est effectuée en utilisant une perte relative de cette section comme une fonction du courant de commande.

**12.** Procédé selon la revendication 11, dans lequel le gain en courant du dispositif laser peut être altéré en utilisant ladite normalisation.

**13.** Procédé selon la revendication 1, dans lequel la normalisation des valeurs de sortie prévoit une détermination de l'emplacement des modes.

**14.** Procédé selon la revendication 13, comprenant en outre l'étape consistant à déterminer des points de fonctionnement adaptés, les points de fonctionnement pouvant être sélectionnés sur la base d'une détermination d'un point central dans les valeurs de fréquence pour un mode spécifique.

**15.** Procédé selon la revendication 14, dans lequel le point de fonctionnement se trouve à la fréquence moyenne pour ce mode et bénéficie de la suppression de mode latéral maximale.

**16.** Procédé selon la revendication 13, dans lequel les modes peuvent être localisés en effectuant une différentiation des valeurs normalisées.

**17.** Programme informatique comprenant des instructions de programme pour faire qu'un ordinateur exécute le procédé selon l'une quelconque des revendications 1 à 16.

**18.** Programme informatique selon la revendication 17 réalisé sur un média d'enregistrement.

**19.** Programme informatique selon la revendication 17 réalisé sur un signal porteur.

**20.** Programme informatique selon la revendication 17 réalisé sur une mémoire en lecture seule.

**21.** Système de commande pour normaliser les valeurs de sortie d'une diode laser, le système comprenant :

des moyens pour varier les courants de commande pour une section spécifique d'un dispositif à diode laser sur une plage de valeurs dans un indice d'échantillon non linéaire afin d'obtenir une série de valeurs de sortie pour cette section de la diode laser, **caractérisé en ce que** le système comprend des moyens pour normaliser la série de valeurs de sortie pour compenser les non-linéarités dans les valeurs de sortie en effectuant une modification dans la relation entre les courants de commande et l'indice d'échantillon non linéaire, ledit indice d'échantillon non linéaire est effectué par une transformée non linéaire appliquée à un indice d'échantillon de courant linéaire, gérant ainsi les courants de commande et les valeurs de sortie de sorte que l'application de la transformée non linéaire effectue une égalisation de la largeur de mode pour obtenir une taille d'étape de largeur de mode uniforme pour un étalonnage ultérieur du laser.

**22.** Système selon la revendication 21, dans lequel les valeurs de sortie sont représentatives de la puissance ou de la fréquence.

**23.** Système selon la revendication 21 ou 22, comprenant en outre des moyens pour obtenir une série de valeurs normalisées pour une ou plusieurs sections supplémentaires du laser.

**24.** Système selon la revendication 21, dans lequel la transformée générée est par la suite utilisée pour effectuer la génération supplémentaire d'une série de valeurs de sortie pour de multiples combinaisons de courants de commande ou sections pour le dispositif laser, la série générée ayant été normalisée en raison de l'utilisation de la transformée.

**25.** Système selon la revendication 21, dans lequel la normalisation des valeurs de sortie est effectuée en utilisant le courant des sauts de mode.

**26.** Système selon la revendication 25, dans lequel les sauts de mode sont détectés par une mesure de la puissance.

**27.** Système selon la revendication 26, dans lequel les sauts de mode sont représentés par des discontinuités dans une mesure de la puissance.

**28.** Système selon la revendication 25, dans lequel les sauts de mode sont détectés par une mesure de la fréquence.

**29.** Système selon la revendication 26, dans lequel les sauts de mode sont représentés par une étape dans la mesure de la fréquence.

**30.** Système selon la revendication 21, comprenant en outre des moyens pour déterminer les déviations de largeur de mode, fournissant ainsi des indications de l'intégrité du dispositif laser.

**31.** Système selon la revendication 21, dans lequel la normalisation est effectuée en utilisant une perte relative de cette section comme une fonction du courant de commande.

**32.** Système selon la revendication 31, dans lequel le gain en courant du dispositif laser peut être altéré en utilisant ladite normalisation.

**33.** Système selon la revendication 21, dans lequel la normalisation des valeurs de sortie prévoit une détermination de l'emplacement des modes.

**34.** Système selon la revendication 33, comprenant en outre des moyens pour déterminer des points de fonctionnement adaptés, les points de fonctionnement pouvant être sélectionnés sur la base d'une détermination d'un point central dans les valeurs de fréquence pour un mode spécifique.

**35.** Système selon la revendication 34, dans lequel le point de fonctionnement se trouve à la fréquence moyenne pour ce mode et bénéficie de la suppression de mode latéral maximale.

**36.** Système selon la revendication 33, dans lequel les modes peuvent être localisés en effectuant une différentiation des valeurs normalisées.

10

9

5

6 4 2

Figure 1

20

23

Laser 21

Coupler 22a

Wavelength
Meter

22b

Coupler

Photodiode A

Photodiode B

Oscilliscope/
Power Meter

24

Current Sources
and
Temperature
Control

26

Communications

PC

25

Figure 2

Linear Power Line

Power

Passive Section Current

Figure 2a

Non-Linear Power Line

Figure 2b

High Resolution Power Line

Figure 3

Plot of Bragg Current vs. Mode Index

Figure 4

Plot of Bragg Current vs. Sample Index

Figure 5

Linear Wavelength Plane of DBR Laser

Figure 6

Non-Linear Wavelength Plane of DBR Laser

Figure 7

Plot of Mode Width vs Bragg Current (Laser with Mode Modulation)

Figure 8

Plot of Mode Width Variation vs Frequency (Laser with Mode Modulation)

Figure 9

Frequency Modulation vs Frequency (Laser with Mode Modulation)

Figure 10

Figure 11

Figure 12

Figure 13

Figure 14

Figure 15

Figure 16

Plot of Mode Jumps of DBR Laser

Figure 17